# EUROPÄISCHE PATENTSCHRIFT

(11) **EP 0 680 094 B1**
(45) Veröffentlichungstag und Bekanntmachung des Hinweises auf die Patenterteilung: **26.02.2003**
(21) Anmeldenummer: 95106282.7
(22) Anmeldetag: 26.04.1995
(51) Int. Cl.: H01L 31/0392, H01L 31/058, H01L 31/036, H01L 31/068, H01L 31/042

(54) **Netzunabhängiger elektrischer Energieverbraucher mit zusätzlicher photovoltaischer Stromversorgung**
Network independent electric device with additional photovoltanic power supply
Appareil électrique à alimentation indépendante du secteur avec alimentation additionnelle de courant photovoltaique

(30) Priorität: 29.04.1994 DE 4415131
(43) Veröffentlichungstag der Anmeldung: 02.11.1995
(73) Patentinhaber: Shell Solar GmbH, 80807 München (DE)
(72) Erfinder: Endrös, Arthur, Dr., D-80337 München (DE); Einzinger, Richard, Dr., D-85643 Steinhöring (DE)
(74) Vertreter: Zeestraten, Albertus Wilhelmus Joannes

(56) Entgegenhaltungen:
- WO-A-95/12220
- WO-A-95/17016
- PATENT ABSTRACTS OF JAPAN vol. 016, no. 031 (E-1159), 27.Januar 1992 -& JP 03 242066 A (TOKYO ELECTRIC CO LTD), 29.Oktober 1991,
- PATENT ABSTRACTS OF JAPAN vol. 015, no. 482 (E-1142), 6.Dezember 1991 -& JP 03 208423 A (MURATA MACH LTD), 11.September 1991,
- "SOLARZELLEN: FLEXIBLE ENERGIEVERSORGUNG" FUNKSCHAU., Nr. 8, April 1983, MUNCHEN DE, Seite 12 XP002059783

## Beschreibung

Die Erfindung betrifft tragbare, netzunabhängige elektrische Energieverbraucher, insbesondere jedoch elektrische Handgeräte, die zum oder wahrend ihres Gebrauchs in der Hand getragen werden. Solche Energieverbraucher bzw. elektrischen Handgeräte besitzen eine Energieversorgung, die durch einen üblicherweise wiederaufladbaren Energiespeicher gepuffert ist. Neben herkömmlichen nichtaufladbaren Batterien wie Alkalizellen, Zinkkohlebatterien oder Quecksilberknopfzellen sind dabei vorzugsweise wiederaufladbare Energiespeicher wie Kondensatoren oder Akkumulatoren geeignet, beispielsweise die bekannten Nickelkadmiumzellen.

Die mögliche maximale Betriebsdauer eines netzunabhängigen Energieverbrauchers ist sowohl von der elektrischen Leistung, die der Energieverbraucher in seinen Betriebszuständen aufnimmt, als auch von der Kapazität des vorhandenen und insbesondere im Energieverbraucher eingebauten Energiespeichers abhängig. Da mit zunehmender Betriebsdauer auch die Verwendbarkeit und die Konkurrenzfähigkeit des Energieverbrauchers steigt, wird allgemein angestrebt, diese durch Verringerung der aufgenommenen Leistung oder durch Erhöhung der Speicherkapazität des Energiespeichers zu verlängern.

Eine weitere Möglichkeit zur Verlängerung der netzunabhängigen Betriebsdauer eines mobilen Energieverbrauchers besteht darin, eine zusätzliche photovoltaische Energieversorgung bereitzustellen. Bei ausreichendem Lichteinfall kann die photovoltaisch erzeugte Energie den Energiespeicher entlasten, ersetzen und/oder wieder aufladen.

Eine zusätzliche photovoltaische Stromversorgung eines mobilen Funktelephons durch Solarzellen, die auf der Oberfläche des Gehäuses angebracht sind, ist in JP-A-03208423 beschrieben.

Leistungsfähige Solarzellen mit Wirkungsgraden über 15 Prozent können bislang nur aus kristallinen Halbleitermaterialien wie Silizium (c-Si) oder Galliumarsenid hergestellt werden. Diese Materialien haben jedoch den Nachteil, daß sich daraus nur ebene oder bestenfalls leicht gekrümmte Solarzellen herstellen lassen, die sich zudem wegen der Zerbrechlichkeit der kristallinen Halbleiter und der daraus folgenden mangelnden Flexibilität nicht oder nicht ausreichend biegen lassen.

Die Verwendung hochleistungsfähiger Solarzellen bei mobilen Energieverbrauchern ist also bislang davon abhängig, daß ausreichend ebene und freie Oberfläche am Verbraucher zur Verfügung steht, die mit den flachen kristallinen Solarzellen bestückt werden kann. Bei kleineren mobilen Energieverbrauchern und insbesondere bei elektrischen Handgeräten ist jedoch meist die Oberfläche begrenzt, auf der üblicherweise Solarzellen aufgebracht werden können. Ohne enormen zusätzlichen Aufwand ist es außerdem nicht möglich, Aussparungen in der Solarzelle vorzusehen, um Platz für erhabene oder versenkte Teile oder den Zugang zu funktionellen Teilen wie Tasten oder Schaltern zu schaffen. Die Belegung der zur Verfügung stehenden flachen und freien Oberfläche des elektrischen Energieverbrauchers ist daher üblicherweise nur mit annäherend rechteckig ausgebildeten oder runden Solarzellen möglich.

Ein weiteres Problem besteht darin, daß wegen der Bruchempfindlichkeit der kristallinen Solarzellen eine erhöhte Materialdicke für die Unterlage und/oder Abdeckung der Solarzelle erforderlich ist, die ein unerwünschtes zusätzliches Gewicht für den tragbaren Energieverbraucher darstellt.

Aufgabe der vorliegenden Erfindung ist es daher, einen solchen tragbaren elektrischen Energieverbraucher anzugeben, der eine verbesserte Energieversorgung aufweist und die oben angegebenen Nachteile vermeidet.

Diese Aufgabe wird erfindungsgemäß gelöst durch einen Energieverbraucher mit den Merkmalen von Anspruch 1. Weitere Ausgestaltungen der Erfindung sind den Unteransprüchen zu entnehmen.

Zur zusätzlichen Energieversorgung des Energieverbrauchers wird erfindungsgemäß zumindest eine Solarzelle auf der Oberfläche des Energieverbrauchers auflaminiert, welche aus einem dünnen Siliziumtrikristall gefertigt ist. Ein solcher Trikristall ist aus einem Artikel von G. Martinelli in Solid State Phenomea Vol. 32-33 (1993) Seiten 21 bis 26 bekannt. Dieser besteht aus drei gegeneinander verkippten monokristallinen Bereichen. Die Phasengrenzen zwischen jeweils zwei der monokristallinen Bereiche werden von Ebenen gebildet, wobei drei solche Ebenen existieren, die sich entlang einer Geraden schneiden, die allen drei Ebenen gemeinsam ist. Vorzugsweise werden die Grenzflächen zwischen jeweils zwei der monokristallinen Bereiche von kristallographisch definierten Ebenen des Siliziumkristalls gebildet und stellen [111]-Ebenen dar. Demzufolge schneiden sich auch die durch diese Grenzflächen definierten Ebenen in kristallographisch vorgegebenen Winkeln, welche vertikal zur gemeinsamen Schnittgeraden gesehen im Idealfallzweimal den Wert von 125,26° und einmal von 109,47° annehmen.

Ein solcher Trikristall hat den Vorteil, daß er keine schräg durch den Kristall laufende [111]-Ebene enthält. Ein herkömmlicher Siliziummonokristall weist vorzugsweise entlang solcher [111]-Ebenen Versetzungen auf, die beim Kristallziehen entstehen und Vorzugsbruchstellen darstellen. Beim Trikristall existiert aber eine den gesamten Kristall durchschneidene Versetzungsebene nicht, so daß ein Zerbrechen entlang einer solchen Ebene unmöglich ist. Ein Auseinanderbrechen entlang der Grenzflächen ist erschwert, da diese im gemeinsamen Schnittpunkt bzw. in der gemeinsamen Schnittachse abgewinkelt sind.

Aus einem solchen Trikristall können Wafer gesägt werden, die außergewöhnlich bruchstabil sind. Dies führt dazu, daß selbst Wafer mit einer Dicke von nur 60 µm in hoher Ausbeute von zum Beispiel 95 Prozent aus dem Trikristall gesägt werden können, die für sich wiederum nicht nur außergewöhnlich bruchstabil sondern sogar ungewöhnlich flexibel sind. Mit Hilfe geeigneter Verfahren (Laminieren) läßt sich ein dünner Trikristallwafer problemlos biegen, wobei Krümmungsradien bis ca. 1 cm erreicht werden können, ohne daß der Trikristallwafer bricht.

Da auch eine daraus hergestellte Solarzelle die gleichen vorteilhaften mechanischen Eigenschaften wie der Trikristallwafer besitzt, laßt diese sich in einfacher Weise auch auf eindimensional gekrümmten Außenflächen des Energieverbrauchers bzw. dessen Gehäuse aufbringen.

Die Solarzelle ist mit beispielsweise 60 bis 100 um Dicke wesentlich dünner als herkömmliche C-Si Solarzellen, die aus mechanischen Gründen eine Dicke von zum Beispiel 300 µm besitzen müssen. Dies reduziert das Gewicht der Solarzelle und damit das Gewicht des Energieverbrauchers, dessen Handhabung dadurch erleichtert wird.

Eine auf einer gekrümmten Fläche auflaminierte Solarzelle ist bei gleicher Dicke außerdem wesentlich steifer und dadurch mechanisch stabiler als eine auf einem ebenen Substrat auflaminierte Solarzelle. Dadurch wird eine erforderliche mechanische Stabilität bereits mit dünnerer Gesamtschichtdicke (für das Laminat aus Oberflächenmaterial bzw. Gehäusematerial, Solarzelle und Abdeckung) als bei einer vergleichbaren ebenen Ausführung.

Ein weiterer Vorteil der neuartigen Energieversorgung für den erfindungsgemäßen Energieverbraucher besteht in dem verbesserten Wirkungsgrad, der mit einer dünneren Solarzelle erreicht werden kann. Bei ansonsten gleicher Materialqualität erreicht eine dünnere Solarzelle eine höhereLeerlaufspannung bei ansonsten gleichbleibendem Kurzschlußstrom und Füllfaktor. Außerdem kann eine dünne Solarzelle auch mit einer niedrigeren Diffusionslänge der Minoritätsladungsträger, also mit einer niedrigeren elektronischen Qualität des Siliziums den gleichen Wirkungsgrad erreichen wie eine entsprechend dickere Solarzelle aus einem Material mit größerer Diffusionslänge.

Bei gleicher Außenfläche besitzt ein erfindungsgemäß mit Solarzellen beschichteter Energieverbraucher eine deutlich erhöhte netzunabhängige Betriebsdauer als ein mit herkömmlichen Solarzellen gleicher Materialqualität beschichteter. Gegenüber einem Energieverbraucher mit herkömmlichen Solarzellen ist der erfindungsgemäße Energieverbraucher außerdem leichter, mechanisch stabiler und kann ein ansprechenderes Design aufweisen, da die flexiblen Solarzellen auch auf eindimensional gekrümmten Oberflächen auflaminiert werden können.

Die erforderlichen Solarzellen können zu einem wesentlich geringeren Preis zur Verfügung gestellt werden, da allein die Materialersparnis ca. 75 Prozent gegenüber herkömmlichen Solarzellen aus monokristallinem Silizium beträgt. Zur weiteren Kosteneinsparung auf der Solarzellenseite kommt hinzu, daß der Kristallziehprozeß des Trikristalls schneller erfolgen kann, daß die Abkühlung des gezogenen Trikristalls weniger Zeit beansprucht und daß der Ziehprozeß wegen der fehlenden Versetzungsgefahr des Kristallgefüges öfter aus dem gleichen Tiegel erfolgen kann als beim Ziehen eines Monokristallstabs.

Ein Energieverbraucher, der auf einer Außenfläche Bedienelemente wie Schalter oder Tasten, Anzeigeelemente oder sonstige Erhöhungen oder Vertiefungen aufweist, kann in einer Ausführungsform der Erfindung auch auf dieser Fläche auflaminierte Solarzellen aufweisen. An den für die genannten Bedienungselemente oder das Display vorgesehenen Stellen weist die auflaminierte Solarzelle Aussparungen auf. Die Aussparungen können dabei sowohl am Rand der auflaminierten Solarzelle als auch innen liegend angeordnet sein. Es ist also nicht nur möglich, Solarzellen mit beliebig geformter Grundfläche herzustellen, sondern auch runde und eckige Löcher oder anders geformte Aussparungen im Inneren der Solarzelle vorzusehen. Ein solches "Zurechtschneiden" ist bei herkömmlichen monokristallinen Solarzellen wegen deren erhöhter Bruchgefahr nicht möglich.

Durch die Möglichkeit, entsprechende Aussparungen in der oder den Solarzellen vorzusehen, wird die mit Solarzellen belegbare Außenfläche des Energieverbrauchers erhöht, wobei sich auch die zusätzlich durch die Solarzellen zur Verfügung gestellte Leistung erhöht. Damit erhöht sich auch die netzunabhängige Betriebsdauer.

In einer bevorzugten Ausführung der Erfindung ist der erfindungsgemäße Energieverbraucher ein Mobiltelephon oder ein schnurloses Telephon. Schnurlose Telephone benötigen Leistungen von weniger als 100 mW im stand by-Betrieb und etwa 250 mW im Sendebetrieb. Mobile Funktelephone nach dem GSM-Standard, die im deutschen D-Netz betrieben werden können, benötigen typische Leistungen von 175 mW im stand by-Betrieb und ca. 2 Watt im Sendebetrieb.

Allein mit den zur Zeit zur Verfügung stehenden Batterien oder Akkumulatoren erlaubt dies typische Gesprächsdauern von 1 bis 2 Stunden, nach denen die Akkumulatoren wieder aufgeladen werden müssen. Hierdurch ist ein vollständig mobiler, das heißt vollständig netzunabhängiger Betrieb dieser Telephone nur sehr bedingt möglich.

Bei ausreichender Sonneneinstrahlung wird die typische Gesprächsdauer für ein erfindungsgemäß ausgestaltetes Mobiltelephon um einen Faktor von ca. 2 erhöht. Unter der Annahme eines mittleren Sammelwirkungsgrads von 18 bis 20 Prozent der Solarzelle und einer mit Solarzellen beschichteten Oberfläche von 100 cm² wird bei einer AM 1,5-Beleuchtung eine Spitzenleistung von 2 Watt erhalten, die sogar einen netzunabhängigen Dauergesprächsbetrieb für das erfingunsgemäße Mobiltelephon ermöglichen würde. Da mit herkömmlichen Solarzellen nur eine wesentlich geringere Oberfläche zur Beschichtung zur Verfügung steht, wird dieser Erfolg mit herkömmlichen Solarzellen nicht erreicht.

In einer weiteren Ausgestaltung der Erfindung ist vorgesehen, daß der Energieverbraucher und insbesondere das tragbare Telephon zumindest ein ausklappbares und mit Solarzellen beschichtetes Teil aufweist, welches die zur Verfügung stehende und nach der Sonne ausrichtbare Solarzellenfläche erhöht. Das ausklappbare Teil kann dabei eine zusätzliche Funktion erfüllen und beispielsweise gleichzeitig eine Abdeckung für die Bedienelemente des Energieverbrauchers und insbesondere des Telephons darstellen. Möglich ist es auch, zwei einander gegenüberliegende Hauptflächen des Energieverbrauchers bzw. des Telephons mit Solarzellen zu beschichten und eine dieser Hauptflächen insbesondere die Rückseite als klappbare Abdeckung auszuführen. Dadurch ist es möglich, den Verbraucher im Ruhezustand aufzuklappen, die zur Sonne ausrichtbare Solarzellenfläche zu vergrößern und ein schnelleres Aufladen des Energiespeichers zu ermöglichen. Beim Betrieb des Energieverbrauchers also beispielsweise beim Telephonieren wird die Abdeckung wieder zurückgeklappt, so daß das Gerät bzw. das Telephon wieder seine ursprüngliche kompakte Form erhält, die eine gute Handhabbarkeit gewährleistet.

Im folgenden wird die Erfindung anhand von Ausführungsbeispielen und der dazugehörigen sechs Figuren näher erläutert.
Figur 1 zeigt einen Trikristallwafer in der Draufsicht,
Figur 2 zeigt ein Laminat im schematischen Querschnitt und
die Figuren 3 bis 6 zeigen erfindungsgemäße Energieverbraucher Telephone aus verschiedenen Ansichten.

Gleiche oder einander entsprechende Teile sind mit gleichen Bezugszeichen versehen.

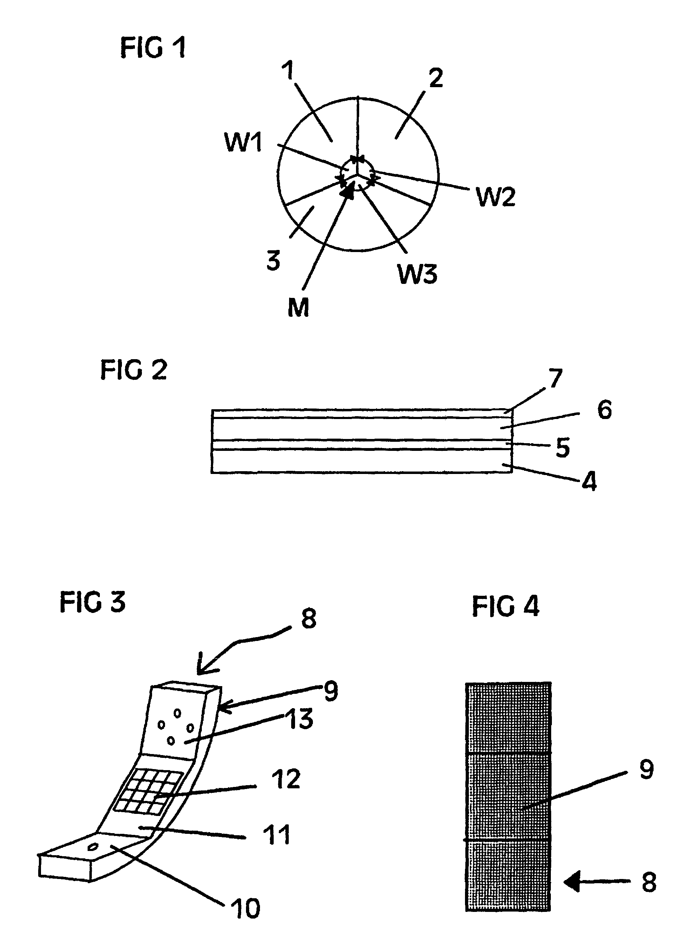

Figur 1 zeigt einen Trikristallwafer, wie er zur Herstellung von Solarzellen für den erfindungsgemäßen Energieverbraucher verwendet werden kann. Drei monokristalline Bereiche 1, 2 und 3 sind durch geradlinig verlaufende Phasengrenzen getrennt. Diese treffen in der Mitte M des Wafers aufeinander und bilden miteinander die Winkel W1, W2 und W3. Sofern die Phasengrenzen zwischen jeweils zwei der monokristallinen Bereiche exakt kristallographischen [111]-Ebenen entsprechen, und der Wafer exakt vertikal zur Mittelachse bzw. zur gemeinsamen Schnittlinie der drei die Phasengrenzen enthaltenden Ebenen gesägt wurde, beträgt der Winkel W3 exakt 109,47°. Bei gleichmäßigem Wachstum sind dann auch die beiden anderen Winkel W2 und W3 exakt gleich groß und betragen 125,26°. Unter den genannten Zucht- und Sägevoraussetzungen haben im Trikristallwafer alle drei monokristallinen Bereiche 1, 2 und 3 eine [110]-Oberfläche. Möglich ist es auch, die Wafer mit nicht vertikal zur Mittelachse gesetzten Sägeschnitten herauszusägen, wobei sich die Winkel W1 bis W3 entsprechend verändern können. Auch können die Begrenzungsflächen um ± 2 Prozent bezüglich der Winkel von den idealen [111] Ebenen abweichen.

Aus dem Trikristallwafer mit einer Dicke von 60 bis 100 um kann mit herkömmlichen Verfahrensschritten eine Solarzelle gefertigt werden. In einem leicht p-dotierten Siliziumtrikristallwafer wird dazu ein pn-Übergang durch Eindiffusion von Phosphor erzeugt, beispielsweise bis zu einer Tiefe von 1 µm.

Front- und Rückkontakt der Solarzelle können beispielsweise durch Siebdruck aufgebracht werden.

Zur Reduzierung der Oberflächenrekombination von Ladungsträgerpaaren wird nach dem Herstellen der Kontakte eine Passivierungsschicht aufgebracht, beispielsweise durch Aufwachsen eines Oxids.

Vor dem Durchführen der genannten Schritte kann die als Lichteinfallsseite der Solarzelle dienende Oberfläche des Trikristallwafers durch Strukturätzen, beispielsweise mittels einer Lochmaske, mit einer aufgerauhten Oberflächenstruktur versehen werden. Diese verbessert die Lichteinfallsgeometrie, indem sie Reflexionsverluste vermeidet.

Als weitere leistungssteigernde Maßnahmen für die Solarzellen kann ein back surface field erzeugt werden, beispielsweise durch Eindiffusion von Bor oder Aluminium in die Rückseite des Wafers bzw. der Solarzelle. Eine ausschließlich im Bereich der Frontkontakte aufgebrachte flache n++ Dotierung erhöht den Wirkungsgrad weiter.

Diese und weitere nicht erfindungsgemäße Verfahrensschritte zur Herstellung einer Solarzelle aus einem Trikristallwafer können der WO-A-9517016, die zum Stand der Technik gemäß Artikel 54(3) EPÜ gehört, entnommen werden. Für die Erfindung ist es allein ausschlaggebend, daß die Solarzelle aus einem dünnen Trikristallwafer hergestellt ist, welcher ausreichend flexibel ist, um auch auf eindimensional gekrümmten Oberfläche eines Verbrauchers auflaminiert werden zu können.

Figur 2 zeigt im schematischen Querschnitt eine auf eine Oberfläche auflaminierte Solarzelle. Die Oberfläche 4 ist die Außenfläche des Energieverbrauchers und ist üblicherweise aus dem Gehäusematerial des Energieverbrauchers, beispielsweise aus Kunststoff oder einem Metall wie Aluminium gefertigt. Zum Auflaminieren wird zwischen der Solarzelle 6 und der Oberfläche 4 eine Klebefolie 5 angeordnet, beispielsweise eine Schmelzklebefolie aus einem thermoplastischen Kunststoff. Zur Abdeckung und Versiegelung der Solarzelle 6 dient eine weitere Kunststoffolie 7, welche ebenfalls eine Schmelzklebefolie sein kann, oder eine mit Hilfe einer Schmelzklebefolie auflaminierte Schutzfolie aus einem widerstandsfähigen, transparenten Kunststoffmaterial, beispielsweise aus perfluoriertem Polyethylen.

Zum Laminieren werden die Schichten in der angegebenen Reihenfolge übereinander gelegt und bei gleichzeitig ausgeübtem Anpreßdruck über den Erweichungspunkt der Schmelzklebefolie erhitzt. Ein gleichzeitig angelegtes Vakuum erleichtert den Laminierprozeß.

In geeigneten Vorrichtungen kann das Auflaminieren der Solarzellen 6 auch auf eindimensional gekrümmten Oberflächen 4 erfolgen. Das Laminat ist nun ausreichend stabil und kann einem weiteren Formgebungsprozeß unterworfen werden, beispielsweise einem Stanzoder Sägeprozeß, um das Laminat in eine gewünschte Form zu bringen, oder, wenn erforderlich, Aussparungen auszusägen oder auszustanzen.

Figur 3 zeigt als Ausführungsbeispiel für einen mobilen Energieverbraucher ein Funktelephon 8 mit auflaminierten flexiblen Solarzellen in perspektivischer schematischer Darstellung. Erfindungsgemäß kann beim Funktelephon 8 eine oder mehrere der Oberflächenbereiche mit den Solarzellen beschichtet sein. Die größte zusammenhängende Oberfläche stellt in diesem Fall die Rückseite 9 dar. Möglich ist es jedoch auch, die hier dreigeteilte Vorderseite des Funktelephons 8 mit Solarzellen zu versehen, und den Mikrophonteil 10, den Bedienungsteil 11 und den Lautsprecherteil 13 mit Solarzellen zu beschichten. Durch Aussägen oder Ausstanzen von Aussparungen bleiben dabei Öffnungen für das Mikrophon, für den Lautsprecher und für das Tastenfeld 12 frei.

Figur 4 zeigt die Rückseite 9 des Funktelephons 8, die wie in Figur 3 dargestellt eindimensional gekrümmt sein kann. Sie ist vollständig mit einer oder mehreren Solarzellen versehen, wobei eine Solarzelle auch über abgerundete Kanten auflaminiert sein kann, die Krümmungsradien bis herab zu 1 cm aufweisen.

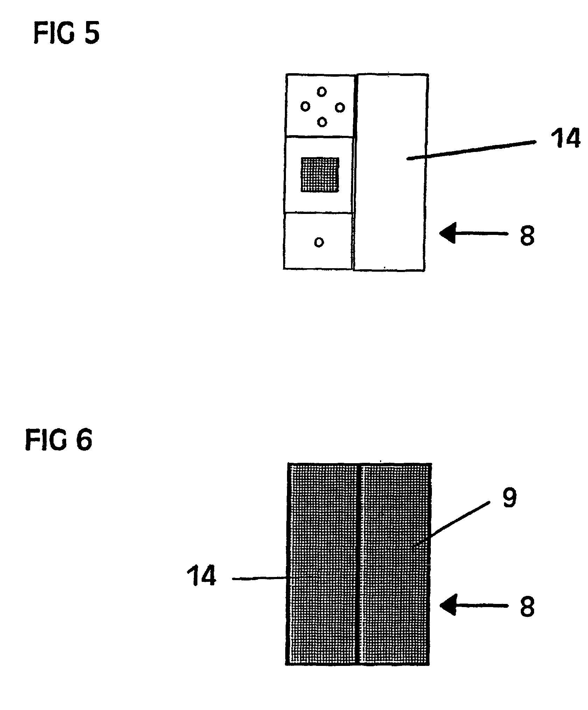

Figur 5 zeigt als weiteres Ausführunsbeispiel für einen erfindungsgemäßen Energieverbraucher ein anders ausgestaltetes Funktelephon in der Draufsicht. Dieses Telephon weist eine seitlich abklappbare Abdeckung 14 auf, die auf der Rückseite (in der Figur nicht dargestellt) mit flexiblen auflaminierten Solarzellen beschichtet ist. Die Abdeckung 14 kann eine Abdeckung für die Vorderseite des Funktelephons und somit einen Schutz der funktionellen Teile wie Tastenfeld, Mikrophon und Lautsprecherteil darstellen. Möglich ist es jedoch auch, auf der Rückseite eine seitlich abklappbare Abdeckung 14 vorzusehen.

Figur 6 zeigt das in Figur 5 dargestellte Telephon von hinten. Sowohl die Rückseite 9 sowie die sichtbare Seite der aufgeklappten Abdeckung 14 sind ganzflächig mit flexiblen Solarzellen beschichtet.

Vorzugsweise ist die Abdeckung 14 eine Abdeckung für die Rückseite 9 des Telephons. Dabei ist es möglich, die Abdeckung nur im Ruhezustand bzw. im stand by-Betrieb und bei ausreichender Sonneneinstrahlung aufzuklappen. Im Falle eines Gespräches wird die Abdeckung 14 wieder auf die Rückseite aufgeklappt, wobei wieder ein kompaktes und wie in Figur 3 dargestelltes Handgerät erhalten wird. Im zusammengeklappten Zustand verdeckt die Abdeckung 14 die Solarzellen auf der Rückseite 9 des Telephons, so daß im (zugeklappten) Betriebszustand des Telephons die in Figur 6 dargestellten Flächen nicht mehr sichtbar sind. Selbstverständlich ist es auch möglich, die in Figur 6 nicht dargestellten Seiten des Telephons bzw. der Abdeckung 14 ebenfalls mit Solarzellen zu beschichten.

Es ist klar, daß der erfindungsgemäße Energieverbraucher nicht auf die in den Ausführungsbeispielen dargestellten Funktelephone beschränkt ist. Vielmehr können alle elektrisch betriebenen netzunabhangigen Handgerate erfindungsgemäß ausgestaltet sein. Besondere Vorteile bietet die Erfindung stets dann, wenn ein hoher Energieverbrauch ein häufiges Austauschen oder Nachladen des Energiespeichers erfordert, wenn zur einfacheren Handhabung des Handgeräts bzw. Energieverbrauchers ein geringes Gewicht gewünscht ist oder wenn für das Handgerät längere Betriebspausen oder längere Phasen mit wenig Energie verbrauchendem stand by-Betrieb vorgesehen sind.

## Patentansprüche

1. Netzunabhängiger und tragbarer elektrischer Energieverbraucher (8) mit einer durch einen Energiespeicher gepufferten Energieversorgung, wobei
zur zusätzlichen Energieversorgung und zum Wiederaufladen des Energiespeichers zumindest eine flexible Solarzelle auf der Oberfläche auflaminiert ist und die Solarzelle aus einem dünnen Siliziumtrikristallwafer gefertigt ist.

2. Energieverbraucher nach Anspruch 1,
bei dem die aktive Halbleiterschicht (6) der aus dem Siliziumtrikristallwafer gefertigten Solarzelle 60 -- 100µm dick ist.

3. Energieverbraucher nach Anspruch 1 oder 2,
welcher eine zumindest teilweise eindimensional gekrümmte Oberfläche (9) aufweist und bei dem die Solarzelle auf dieser zumindest zum Teil gekrümmten Oberfläche auflaminiert ist.

4. Energieverbraucher nach einem der Ansprüche 1-3,
welcher ein mobiles Funkgerät (8) oder ein schnurloses Telefon (8) ist.

5. Energieverbraucher nach einem der Ansprüche 1-4,
bei dem die auflaminierte Solarzelle Aussparungen aufweist für Bedienungstasten, Schalter oder andere funktionelle Teile (12) des Energieverbrauchers, die gegenüber der Oberfläche (11) des Energieverbrauchers (8) erhaben oder vertieft angeordnet sind.

6. Energieverbraucher nach einem der Ansprüche 1-5,
bei dem die Solarzelle drei gegeneinander verkippte monokristalline Bereiche (1, 2, 3) aufweist, die auf der Oberfläche der Solarzelle durch gerade, sich in einem Punkt schneidende Linien begrenzt sind.

7. Energieverbraucher nach Anspruch 6,
bei dem die sich in einem Punkt schneidenden Linien miteinander Winkel (W1, W2, W3) von 125,26° und 109,47° (jeweils ± 2%) einschließen, und bei dem alle Grenzflächen zwischen jeweils zwei der monokristallinen Bereiche kristallographische [111] Ebenen des Siliziums sind.

## Claims

1. Network-independent and portable electric energy consumer (8) having an energy supply buffered by an energy storage, wherein, for additional energy supply and for recharging the energy storage, at least one flexible solar cell is laminated on the surface and the solar cell is made of a thin silicon tricrystalline wafer.

2. Energy consumer according to claim 1, wherein the thickness of the active semiconductor layer (6) of the solar cell made of the silicon tricrystalline wafer is between 60 and 100 µm.

3. Energy consumer according to claim 1 or 2, which has an at least partly one-dimensionally curved surface (9) and wherein the solar cell is laminated on this at least partly curved surface.

4. Energy consumer according to one of the claims 1-3, which is a mobile radio receiver or a cordless telephone.

5. Energy consumer according to one of the claims 1-4, wherein the laminated solar cell has recesses for control keys, switches or other functional parts (12) of the energy consumer, which are arranged elevated or lowered with respect to the surface (11) of the energy consumer (8).

6. Energy consumer according to one of the claims 1-5, wherein the solar cell includes three monocrystalline regions (1,2,3) arranged against each other, which at the surface of the solar cell are bounded by straight lines intersecting in one point.

7. Energy consumer according to claim 6, wherein the in one point intersecting lines inclose between each other angles (W1, W2, W3) of 125.26° and 109.47° (each ± 2%), and wherein all boundary planes between two monocrystalline regions are crystallographic [111] planes of the silicon.

## Revendications

1. Appareil consommateur d'énergie électrique (8) indépendant du secteur et portable comprenant une alimentation en énergie emmagasinée par un dispositif de stockage d'énergie, dans lequel au moins une cellule solaire flexible est laminée sur la surface et la cellule solaire est fabriquée à partir d'une mince galette tricristalline en silicium pour l'alimentation supplémentaire en énergie et pour le rechargement du dispositif de stockage d'énergie.

2. Appareil consommateur d'énergie selon la revendication 1, dans lequel la couche semi-conductrice (6) active de la cellule solaire fabriquée à partir de la galette tricristalline en silicium a une épaisseur de 60 - 100 µm.

3. Appareil consommateur d'énergie selon la revendication 1 ou 2, lequel présente une surface partiellement courbée de manière unidimensionnelle et dans lequel la cellule solaire est laminée sur cette surface au moins en partie courbée.

4. Appareil consommateur d'énergie selon une des revendications 1-3, lequel est un appareil radio (8) mobile ou un téléphone sans fil (8).

5. Appareil consommateur d'énergie selon une des revendications 1-4, dans lequel la cellule solaire laminée présente des encoches pour des touches de commandes, des commutateurs ou d'autres parties fonctionnelles (12) de l'appareil consommateur d'énergie qui sont disposées en relief ou en creux par rapport à la surface (11) de l'appareil consommateur d'énergie (8).

6. Appareil consommateur d'énergie selon une des revendications 1-5, dans lequel la cellule solaire présente trois zones monocristallines (1, 2, 3) basculées les unes par rapport aux autres qui sont limitées sur la surface de la cellule solaire par des lignes droites se coupant en un point.

7. Appareil consommateur d'énergie selon la revendication 6, dans lequel les lignes se coupant en un point forment ensemble des angles (W1, W2, W3) de 125,26° et de 109,47° (respectivement ± 2 %) et dans lequel toutes les surfaces limites entre deux zones monocristallines respectives sont des plans [111] du silicium.
